# EUROPÄISCHE PATENTSCHRIFT

(11) **EP 0 637 081 B1**
(45) Veröffentlichungstag und Bekanntmachung des Hinweises auf die Patenterteilung: **19.09.2001**
(21) Anmeldenummer: 94109985.5
(22) Anmeldetag: 28.06.1994
(51) Int. Cl.: H01L 23/495, H01L 23/31, G01D 11/24, G01P 1/02, H01L 21/56, H01L 43/04, H01R 13/66

(54) **Mikrosensor mit Steckeranschluss**
Micro sensor with plug connections
Micro détecteur avec fiches de connexions

(30) Priorität: 27.07.1993 DE 9311223 U
(43) Veröffentlichungstag der Anmeldung: 01.02.1995
(73) Patentinhaber: TYCO Electronics Logistics AG, 9323 Steinach (CH)
(72) Erfinder: Jansseune, Luc, D-81739 München (DE); Preiner, Peter, D-81479 München (DE)
(74) Vertreter: Klunker . Schmitt-Nilson . Hirsch

(56) Entgegenhaltungen:
- EP-A- 0 294 190
- EP-A- 0 307 946
- EP-A- 0 418 891
- EP-A- 0 419 040
- WO-A-88/09058
- DE-A- 4 142 139
- DE-A- 4 218 793
- US-A- 4 947 236
- PATENT ABSTRACTS OF JAPAN vol. 007 no. 258 (E-211) ,17.November 1983 & JP-A-58 145149 (MITSUBISHI DENKI KK) 29.August 1983,
- PATENT ABSTRACTS OF JAPAN vol. 005 no. 059 (E-053) ,22.April 1981 & JP-A-56 010946 (MITSUBISHI ELECTRIC CORP) 3.Februar 1981,

## Beschreibung

Die Erfindung betrifft einen Mikrosensor, insbesondere einen Magnetfeld-Schalter, mit Steckeranschluß, bei dem mindestens ein integrierter Schaltkreis (IC) in einem Kunststoffgehäuse befestigt ist.

Mikrosensoren, wie beispielsweise Hall-Schalter oder Temperaturfühler, werden häufig mit Steckeranschlüssen versehen, um lösbare Verbindungen zu schaffen, oder um teure Kabelanschlüsse zu vermeiden. Bisher werden das Sensor-IC, das beispielsweise die Auswerteschaltung eines Hall-Näherungsschal-ters enthält, sowie eventuelle weitere Komponenten entweder auf eine kleine Leiterplatte bestückt und gelötet oder auf ein Substrat gebondet, bzw., bei hybriden Schichtschaltungen, gedruckt. Dieses Leiterplättchen bzw. dieses Keramiksubstrat wird in einem Kunststoffgehäuse montiert. Erst daraufhin wird zusätzlich noch eine Steckereinheit angebracht und mit dem Leiterplättchen verbunden. Das Ganze wird dann zum Abdichten und Fixieren der Teile meistens mit einer Vergußmasse aus Kunststoff vergossen.

Aus US-A-4 947 236 ist ein Halbleiterbauelement mit SIL-Anschlüssen bekannt, bei dem mindestens ein Bauelement in einem Kunststoffgehäuse befestigt ist, wobei ein Leadframe die Basis für mindestens ein daran befestigtes Bauelement bildet, und wobei das Leadframe aus mehreren länglichen parallel Teilen, deren gehäuseseitigen ersten Enden mit den Anschlüssen des Bauelements elektrisch verbunden und gemeinsam mit dem Bauelement in dem Kunststoffgehäuse eingebettet sind.

Aufgabe der vorliegenden Erfindung ist es, einen Mikrosensor der eingangs genannten Art zu schaffen, der einfacher aufgebaut und deshalb kostengünstiger und zuverlässiger als die bekannten Mikrosensoren ist.

Erfindungsgemäß wird dies dadurch erreicht, daß ein Leadframe die Basis für mindestens einen daran befestigten IC bildet, wobei die ersten Enden des Leadframes mit den Anschlüssen des IC elektrisch verbunden und gemeinsam mit dem IC in dem Kunststoffgehäuse eingebettet sind, und daß die zweiten Enden des Leadframes jeweils als aus dem Gehäuse vorstehende, rein steckbar elektrisch anzuschliessende Steckeranschlußelemente ausgebildet sind.

Weitere Ausgestaltungen der Erfindung sind in den Unteransprüchen gekennzeichnet. Die Erfindung wird nachfolgend an Ausführungsbeispielen anhand der Zeichnung näher erläutert. Es zeigen
- FIG 1 und 2: zwei verschiedene Ansichten eines erfindungsgemäß gestalteten Mikrosensors, jeweils schematisch und im Schnitt,
- FIG 3: in gleicher Darstellungsweise eine Ansicht einer weiteren Ausführung eines erfindungsgemäßen Hall-Näherungsschalters.

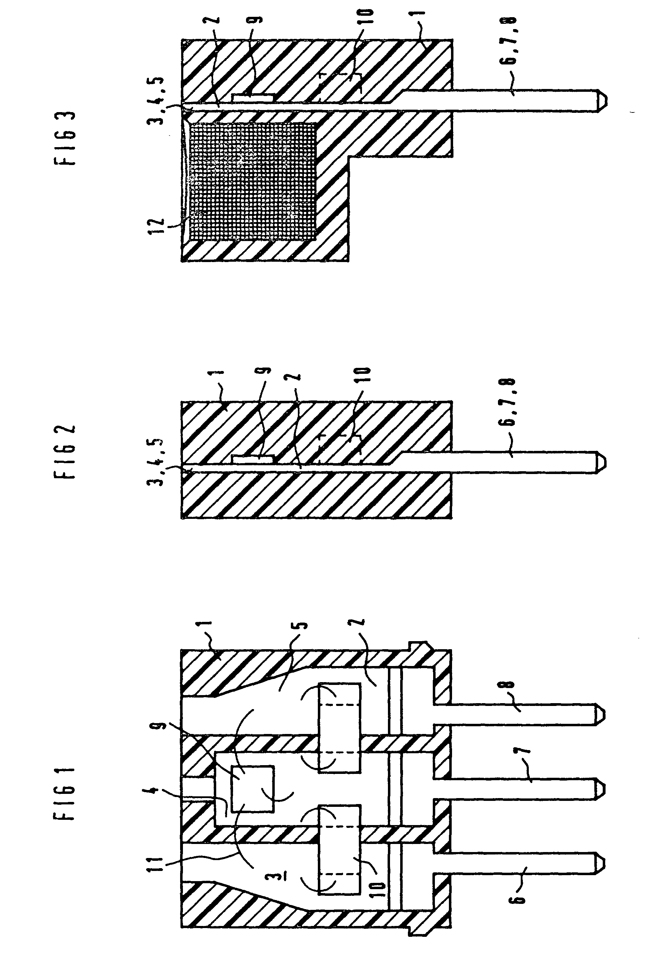

Der in den Figuren 1 bis 3 dargestellte Mikrosensor besitzt ein Gehäuse 1, in dem die ersten Enden (3,4,5) eines Leadframes eingebettet sind. Das aus der Montagetechnologie elektrischer Schaltungen an sich bekannte Leadframe ist ein gestanztes metallisches Band. In FIG 1 ist ein aus drei Leiterstreifen 3, 4 und 5 und zugehörigen drei rein steckbar elektrisch anzuschliessenden Steckeranschlußelementen 6, 7 und 8 bestehendes Leadframe dargestellt. Die ersten Enden 3, 4 und 5 des Leadframes werden als Basis für die Befestigung von ICs und evt. von sonstigen diskreten Komponenten verwendet. In den FIG 1 bis 3 sind jeweils ein Sensor-IC 9 und diskrete Komponenten 10, beispielsweise zur Schutzbeschaltung, dargestellt, wobei in FIG 1 auch die elektrische Verbindung 11 (Bonddrähte) der Bauteile 9 und 10 mit dem Leadframe angedeutet ist. Um die oberen ersten Enden 3, 4 und 5 des Leadframes besser ausstanzen zu können, ist es vorteilhaft, das Leadframe zweistufig auszubilden, wobei, wie in den FIG 2 und 3 angedeutet, die ersten Enden 3, 4 und 5 des Leadframes dünner als die Steckeranschlußelemente 6, 7 und 8 des Leadframes ausgebildet sind. Das Sensor-IC 9 und evtl. die zusätzlichen diskreten Komponenten 10 werden auf die dünne Seite 2 des Leadframes geklebt und beispielsweise mittels Bonden mit dem Leadframe verbunden. Es können ohne weiteres auch mehrere ICs auf dem Leadframe angebracht werden. Danach wird dieser Teil des Leadframes zusammen mit den darauf angeordneten Komponenten mit einem Kunststoff umspritzt.

Die dickere Seite des Leadframes ist so ausgeformt, daß rein steckbar elektrisch anzuschliessende Steckeranschlußelemente 6, 7 und 8 gebildet sind. Diese können insbesondere als Messerkontakte eines Steckverbinders, oder als Crimpanschlüsse, oder als Schneidklemmanschlüsse ausgebildet sein. Es kommen aber auch alle sonstigen rein steckbare elektrische Anschlussarten, wie Flachstecker, Rundstecker oder Vierkantstecker in Betracht.

Die Stecker-Sensoren mit eingebauter "Intelligenz" (IC oder BUS-Schnittstelle) können entweder direkt oder mittels eines Gegensteckers am Einsatzort, beispielsweise einer Maschine, befestigt werden. Die Befestigung kann beispielsweise durch eine Schnappverbindung oder durch seitliche Ösen für Schrauben, oder durch Preßzapfen realisiert werden.

Bei Verwendung eines schaltfähigen Magnetfeld-Sensors können, wie in FIG 3 dargestellt, ein oder mehrere Dauermagneten 12 mit in dem Kunststoffgehäuse 1 eingebettet sein. Durch den erfindungsgemäßen Aufbau mit weniger Teilen resultiert für die Mikrosensoren eine einfachere und deshalb kostengünstigere Montage. Die geringere Anzahl an Kontakten erhöht darüber hinaus die Zuverlässigkeit. Auch die Wärmeabfuhr und, im Fall eines Magnetfeld-Sensors, die Positionierung des Dauermagneten gegenüber der Sensorfläche, ist gegenüber bisher bekannten Ausführungen verbessert.

## Patentansprüche

1. Mikrosensor mit Steckeranschluß, bei dem mindestens ein integrierter Schaltkreis (IC) in einem Kunststoffgehäuse befestigt ist, wobei ein Leadframe die Basis für mindestens einen daran befestigten IC (9) bildet und wobei
das Leadframe aus mehreren länglichen parallelen Teilen besteht, deren gehäuseseitige erste Enden (3, 4, 5) mit den Anschlüssen des ICs (9) elektrisch verbunden und gemeinsam mit dem IC (9) in dem Kunststoffgehäuse (1) eingebettet sind **dadurch gekennzeichnet**,
daß die den ersten Enden (3, 4, 5) gegenüberliegenden zweiten Enden (6, 7, 8) als aus dem Gehäuse (1) vorstehende, rein steckbar elektrisch anzuschliessende Steckeranschlußelemente ausgebildet sind, und
daß das Leadframe zweistufig ausgebildet ist, wobei die ersten Enden (3, 4, 5) des Leadframes flacher als die steckeranschlußseitigen zweiten Enden (6, 7, 8) des Leadframes ausgebildet sind.

2. Mikrosensor nach Anspruch 1,
**dadurch gekennzeichnet,**
**daß** außer dem IC (9) zusätzliche diskrete Bauelemente (10) an den ersten Enden (3, 4, 5) des Leadframes befestigt und mit diesen elektrisch verbunden sind.

3. Mikrosensor nach einem der Ansprüche 1 bis 2,
**dadurch gekennzeichnet,**
**daß** ein Sensor-IC und ein BUS-Schnittstellen-IC auf dem Leadframe angeordnet sind.

4. Mikrosensor nach einem der Ansprüche 1 bis 3,
**dadurch gekennzeichnet,**
**daß** der Mikrosensor als schaltfähiger Magnetfeld-Sensor ausgebildet ist und daß mindestens ein Dauermagnet (12) mit im Kunststoffgehäuse (1) eingebettet ist.

5. Mikrosensor nach einem der Ansprüche 1 bis 4,
**dadurch gekennzeichnet,**
**daß** die Steckeranschlußelemente (6, 7, 8) als Messerkontakte eines Steckverbinders ausgebildet sind.

6. Mikrosensor nach einem der Ansprüche 1 bis 4,
**dadurch gekennzeichnet,**
**daß** die Steckeranschlußelemente (6, 7, 8) als Crimpanschlüsse ausgebildet sind.

7. Mikrosensor nach einem der Ansprüche 1 bis 4,
**dadurch gekennzeichnet,**
**daß** die Steckeranschlußelemente (6, 7, 8) als Schneidklemmanschlüsse ausgebildet sind.

## Claims

1. A microsensor having a connector terminal, in which at least one integrated circuit (IC) is secured in a synthetic housing, a leadframe forming the base of at least one IC (9) secured thereto, and the leadframe comprising a plurality of elongate parallel parts whereof the first ends (3, 4, 5), at the housing end, are electrically connected to the terminals of the IC (9) and are embedded together with the IC (9) in the synthetic housing (1), **characterised in that** the second ends (6, 7, 8) lying opposite the first ends (3, 4, 5) are constructed as connector terminal elements which project out of the housing (1) and are to be electrically connected purely by insertion, and in that the leadframe is of two-stepped construction, the first ends (3, 4, 5) of the leadframe being flatter than the second ends (6, 7, 8) at the connector terminal end of the leadframe.

2. A microsensor according to Claim 1, **characterised in that** apart from the IC (9) additional discrete structural elements (10) are secured to the first ends (3, 4, 5) of the leadframe and are electrically connected to these ends.

3. A microsensor according to one of Claims 1 to 2, **characterised in that** a sensor IC and a bus interface IC are arranged on the leadframe.

4. A microsensor according to one of Claims 1 to 3, **characterised in that** the microsensor is constructed as a switchable magnetic field sensor, and in that at least one permanent magnet (12) is also embedded in the synthetic housing (1).

5. A microsensor according to one of Claims 1 to 4, **characterised in that** the connector terminal elements (6, 7, 8) are constructed as the blade contacts of a plug connector.

6. A microsensor according to one of Claims 1 to 4, **characterised in that** the connector terminal elements (6, 7, 8) are constructed as crimp connections.

7. A microsensor according to one of Claims 1 to 4, **characterised in that** the connector terminal elements (6, 7, 8) are constructed as insulation displacement connections.

## Revendications

1. Microcapteur avec connexions à fiche, comportant au moins un circuit intégré (IC) fixé dans un boîtier en plastique, un réseau de conducteurs constituant la base d'au moins un circuit intégré (9) qui y est fixé, le réseau de conducteurs étant composé de plusieurs parties parallèles longitudinales, dont les premières extrémités du côté du boîtier (3, 4, 5) sont reliées électriquement avec les connexions du circuit intégré (9) et encastrées ensemble avec le circuit intégré (9) dans le boîtier en plastique (1), **caractérisé en ce que** les deuxièmes extrémités (6, 7, 8) opposées aux premières extrémités (3, 4, 5) sont conçues sous forme d'éléments de connexion à fiche, à simple connexion électrique par enfichage, débordant du boîtier (1), le réseau de conducteurs ayant une forme à deux niveaux, les premières extrémités (3, 4, 5) du réseau de conducteurs étant plus plates que les deuxièmes extrémités du côté du connexion à fiche (6, 7, 8).

2. Microcapteur selon la revendication 1, **caractérisé en ce que** des composants discrets supplémentaires (10) sont fixés sur les premières extrémités (3, 4, 5) du réseau de conducteurs, en plus du circuit intégré (9), et reliés électriquement à celles-ci.

3. Microcapteur selon l'une des revendications 1 ou 2, **caractérisé en ce qu'**un circuit intégré du capteur et un circuit intégré d'interface BUS sont agencés sur le réseau de conducteurs.

4. Microcapteur selon l'une des revendications 1 à 3, **caractérisé en ce que** le microcapteur est conçu sous forme d'un capteur à champ magnétique commutable, au moins un aimant permanent (12) étant aussi encastré dans le boîtier en plastique (1).

5. Microcapteur selon l'une des revendications 1 à 4, **caractérisé en ce que** les éléments de connexion à fiche (6, 7, 8) sont conçus sous forme de contacts à couteau d'un connecteur.

6. Microcapteur selon l'une des revendications 1 à 4, **caractérisé en ce que** les éléments de connexion à fiche (6, 7, 8) sont conçus sous forme de connexions à sertissage.

7. Microcapteur selon l'une des revendications 1 à 4, **caractérisé en ce que** les éléments de connexion à fiche (6, 7, 8) sont conçus sous forme de connexions à déplacement d'isolation.
